# EUROPÄISCHE PATENTANMELDUNG

(11) **EP 1 143 487 A1**
(43) Veröffentlichungstag der Anmeldung: **10.10.2001**
(21) Anmeldenummer: 00112472.6
(22) Anmeldetag: 10.06.2000
(51) Int. Cl.: H01L 21/00

(54) **Linearführung mit einem Luftlager**

(30) Priorität: 04.04.2000 EP 00810296
(71) Anmelder: ESEC Trading S.A., 6330 Cham (CH)
(72) Erfinder: Probst, Urs, 1004 Lausanne (CH)
(74) Vertreter: Falk, Urs, Dr.

(57) **Zusammenfassung**

Eine Linearführung (1) umfasst ein Trägerelement (2) und einen auf dem Trägerelement (2) gleitenden Schlitten (3). Der Schlitten (3) weist zwei auf dem Trägerelement (2) gleitende, luftgelagerte Hohlzylinder (4) und (5) und einen dazwischen angeordneten Körper (6) auf. Das Trägerelement (2) und die beiden Hohlzylinder (4) und (5) des Schlittens (3) sind durch einen mit Druckluft beaufschlagbaren Spalt (7) getrennt. Als Antriebsvorrichtung für den Schlitten (3) ist ein aus einem u-förmigen Stator (8) und einem Läufer (9) gebildeter Linearmotor vorgesehen. Im Betrieb entsteht im Läufer (9) Verlustwärme, die den Schlitten (3) erwärmt. Um Änderungen der Dicke des Spaltes (7) innerhalb vorgegebener Grenzen zu halten, werden diejenigen Teile des Schlittens (3), deren Temperatur die Dicke des Spalts (7) beeinflusst, entweder gekühlt oder auf eine vorbestimmte Temperatur aufgeheizt.

## Beschreibung

Die Erfindung betrifft eine Linearführung mit einem Luftlager der im Oberbegriff des Anspruchs 1 genannten Art.

Bei der Montage von Halbleiterchips kommen als "Die Bonder" bekannte Montageautomaten zum Einsatz, die dazu dienen, die zahlreichen, gleichartigen Chips eines Wafers, die sich nebeneinander auf einem Träger befinden, nacheinander auf einem Substrat, z.B. einem metallischen Leadframe, zu montieren. Koordiniert mit der Pick-and-Place-Bewegung eines Chipgreifers stellt jeweils ein Wafertisch, auf dem sich der Chipträger befindet, einen nächsten Chip bereit, und ebenso wird das Substrat verschoben, um an einem zweiten Ort einen neuen Substratplatz bereitzustellen. Zum Abheben und nachfolgenden Ablegen der Chips ist der Chipgreifer in bekannter Weise heb- und senkbar.

An solche Die Bonder werden extrem hohe Anforderungen gestellt, insbesondere an die Lagerung der bewegten Teile. Für die Weiterverarbeitung der montierten Chips müssen diese lagegenau auf dem Substrat positioniert werden, was ein entsprechend genaues Erreichen des zweiten Ortes durch den Chipgreifer verlangt und auch bereits das genaue Anfahren des ersten Ortes für das Abheben der Chips voraussetzt. Anderseits werden auch hohe Geschwindigkeiten bzw. kurze Taktzeiten verlangt, wodurch entsprechend hohe Beschleunigungen und Massenkräfte an den bewegten Teilen auftreten.

Zur Erzeugung der alternierenden Bewegungen des Chipgreifers werden bisher verschiedene Hebelmechanismen angewendet, die teilweise Kulissenführungen enthalten. Derartige Führungen sind wegen der an ihnen auftretenden, erheblichen Kräfte für einen präzisen Bewegungsablauf nachteilig und müssen entsprechend gewartet werden. Bei einem änderen bekannten Mechanismus sitzt der Chipgreifer am Ende eines hin und her schwenkenden Hebels, d.h. er erfährt entsprechend den Schwenkausschlägen des Hebels eine bogenförmige Bewegung, die jeweils in den Endlagen gestoppt werden muss, wobei eine starke Neigung zu Schwingungen besteht. Ein Nachteil solcher Hebelantriebe liegt darin, dass sie nur einen Transport des Chips um eine feste, vorbestimmte Strecke von einem Ort A zu einem Ort B erlauben.

Bekannt sind auch Antriebe, bei denen der Chipgreifer mittels eines Zahnriemens angetrieben wird. Nachteilig ist hier die grosse Ungenauigkeit der Plazierung des Chips auf dem Substrat.

Der Erfindung liegt die Aufgabe zugrunde, einen Antrieb für das Pick and Place System eines Die Bonders zu entwickeln, das den Transport eines Halbleiterchips bei hoher Genauigkeit der Plazierung über beliebige Strecken erlaubt.

Die genannte Aufgabe wird erfindungsgemäss gelöst durch eine für ein Pick und Place System eines Die Bonders geeignete Linearführung mit den Merkmalen des Anspruchs 1.

Nachfolgend werden Ausführungsbeispiele der Erfindung anhand der Zeichnung näher erläutert.

Es zeigen:
- Fig. 1: eine Linearführung, mit einem Trägerelement und einem Schlitten, und eine Antriebsvorrichtung für den Schlitten, und
- Fig. 2, 3: das Trägerelement und den Schlitten im Querschnitt,

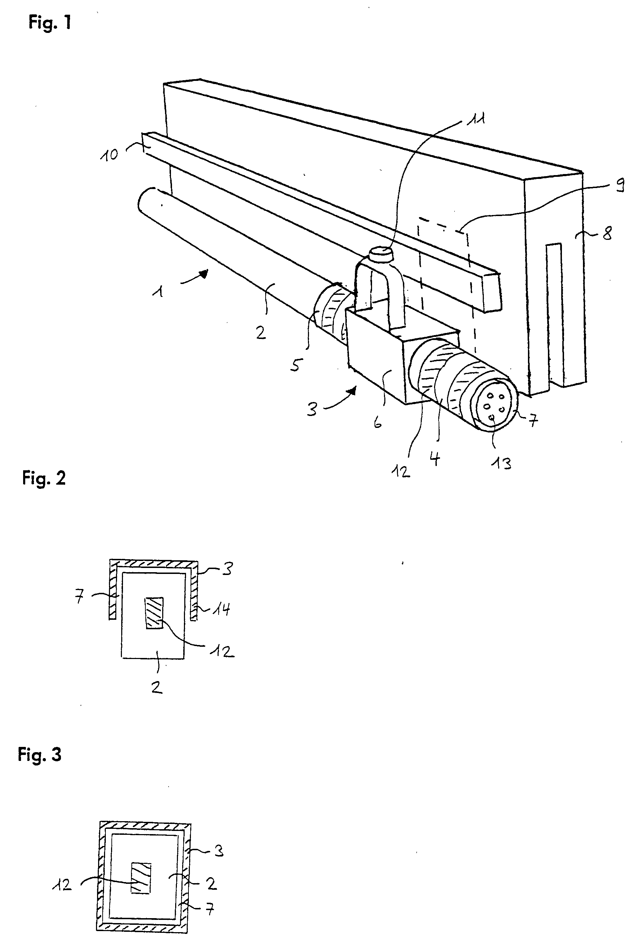

Die Fig. 1 zeigt in perspektivischer Ansicht eine Linearführung 1, die ein Trägerelement 2 und einen auf dem Trägerelement 2 gleitenden Schlitten 3 umfasst. Das Trägerelement 2 ist ein zylindrischer Stab. Der Schlitten 3 weist zwei auf dem Trägerelement 2 gleitende, luftgelagerte Hohlzylinder 4 und 5 und einen dazwischen angeordneten Körper 6 auf. Das Trägerelement 2 und die beiden Hohlzylinder 4 und 5 des Schlittens 3 sind durch einen mit Druckluft beaufschlagbaren Spalt 7 getrennt. Die Zuführung der Druckluft erfolgt über an den Innenwänden der beiden Hohlzylinder 4 und 5 angebrachte Düsen. Die Luftlagerung des Schlittens 3 ermöglicht eine verschleissfreie Bewegung des Schlittens 3 entlang des Trägerelementes 2. Die beiden Hohlzylinder 4 und 5 sind bevorzugt aus einem einzigen Teil geformt, wobei der Körper 6 etwa in der Mitte dieses Teils angeordnet ist.

Als Antriebsvorrichtung für den Schlitten 3 ist ein aus einem u-förmigen Stator 8 und einem Läufer 9 gebildeter Linearmotor vorgesehen. Der Läufer 9 ist in dieser Perspektive nicht sichtbar und daher mit einer gestrichelten Linie angedeutet. Für nähere Details der Antriebsvorrichtung wird auf die europäische Patentanmeldung Nr. 98810988.0 verwiesen, die hiermit explizit eingeschlossen wird. Der Läufer 9 ist starr mit dem Körper 6 des Schlittens 3 verbunden. Infolge seines Gewichts übt der Läufer 9 ein Drehmoment auf den Schlitten 3 auf. Zur Aufnahme des Drehmomentes ist eine Schiene 10 vorgesehen, auf der ein am Körper 6 des Schlittens 3 angebrachtes Laufrad 11 rollt. Um den permanenten Kontakt des Laufrades 11 mit der Schiene 10 zu gewährleisten, ist bevorzugt ein zweites, federnd gelagertes (nicht dargestelltes) Laufrad vorgesehen, das auf der Rückseite der Schiene 10 rollt. Alternativ kann ein mit Vakuum vorgespanntes Luftlager vorgesehen sein, indem anstelle des Laufrades 11, bzw. der beiden Laufräder, ein am Körper 6 befestigtes Teil mit einer bezüglich der Schiene 10 mit Vakuum vorgespannten und mit Luft beaufschlagten Gleitfläche vorhanden ist.

Die beschriebene Linearführung und der Linearmotor können z.B. als Pick and Place System eines Die Bonders eingesetzt werden. Im Betrieb erzeugt der durch den Läufer 9 fliessende Strom Wärme, die auch den Schlitten 3 erwärmt und infolge damit verbundener Längenänderungen des Schlittens 3 und des Trägerelementes 2 zu einer Änderung der Dicke des Spaltes 7 führt. Im Extremfall kann dies dazu führen, dass entweder der Luftspalt kleiner und kleiner wird und der Schlitten 3 unter Belastung das Trägerelement 2 berührt, oder dass der Luftspalt grösser und grösser wird, wodurch sich Eigenschaften wie die Steifigkeit oder die Tragkraft des Luftlagers verschlechtern. Um Änderungen der Dicke des Spaltes 7, die ein vorbestimmtes Mass übersteigen, auszuschliessen, wird erfindungsgemäss vorgeschlagen, diejenigen Teile der Linearführung, deren Temperatur Einfluss auf die Dicke des Spaltes 7 hat, auf einer vorbestimmten Temperatur bzw. innerhalb eines vorgegebenen Temperaturbandes zu halten. Dazu sind entweder Kühlelemente oder Heizelemente vorgesehen. Bevorzugt wird die Temperatur geregelt. Der Wert, auf den die Temperatur geregelt wird, ist entsprechend der vom Läufer 9 im Extremfall zugeführten Wärmemenge so bestimmt, dass der Schlitten 3 das Trägerelement 2 keinesfalls touchiert und dass auch die Steifigkeit des Luftlagers innerhalb vorgegebener Grenzwerte erhalten bleibt. Beispiele werden nun näher erläutert:

### Beispiel 1

Elektrische Heizelemente sind innerhalb des Trägerelementes 2 angeordnet. Die Abmessungen des Trägerelementes 2 und der Hohlzylinder 4 und 5 sind entsprechend den thermischen Ausdehnungskoeffizienten der für sie verwendeten Materialien so gewählt, dass die Dicke des Spaltes 7 beispielsweise 8 µm beträgt, wenn die Temperatur des Trägerelementes 2 auf einen Wert von 60° C geregelt wird. Für die Messung der Temperatur ist im Trägerelement 2 ein Temperaturfühler angeordnet.

### Beispiel 2

Hier sind die beiden Hohlzylinder 4 und 5 des Schlittens 3 mit elektrischen Heizelementen 12 versehen, um ihre Temperatur innerhalb eines vorbestimmten Toleranzbandes zu halten. Bevorzugt wird die Temperatur auf einen vorbestimmten Wert geregelt. Dazu ist im Hohlzylinder 4 oder 5 ein Temperaturfühler angeordnet. Wiederum sind die Abmessungen des Trägerelementes 2 und der Hohlzylinder 4 und 5 entsprechend den thermischen Ausdehnungskoeffizienten der für sie verwendeten Materialien so gewählt, dass die Dicke des Spaltes 7 beispielsweise 8 um beträgt, wenn die Temperatur der Hohlzylinder 4 und 5 auf einen Wert von 60° C geregelt wird.

### Beispiel 3

Möglich ist auch die Kombination der beiden Beispiele, d.h. der Einsatz von Heizelementen sowohl im Trägerelement 2 als auch bei den Hohlzylindern 4 und 5. Zudem ist es möglich, das Trägerelement 2 auf eine andere Temperatur zu regeln als die beiden Hohlzylinder 4 und 5.

### Beispiel 4

Bei diesem Beispiel wird das Trägerelement 2 nicht auf eine vorbestimmte Temperatur aufgeheizt sondern gekühlt, entweder ungeregelt oder geregelt auf eine vorbestimmte Temperatur. Das Trägerelement 2 weist deshalb Längsbohrungen 13 auf, die entweder mit Druckluft beaufschlagt oder von einem Kühlmittel durchströmt werden, wobei die Temperatur des Kühlmittels vorzugsweise geregelt wird.

### Beispiel 5

Es ist auch möglich, das Trägerelement 2 zu kühlen und den Schlitten 3 zu beheizen.

### Beispiel 6

Eine wichtige Teilaufgabe, die die Erfindung lösen soll, besteht darin, den Einfluss der im Betrieb vom Läufer 9 dem Luftlager zugeführten Verlustwärme zu begrenzen, bzw. die Dicke des Spaltes 7 zwischen dem Trägerelement 2 und dem Hohlzylinder 4 bzw. 5 innerhalb vorgegebener Grenzen zu halten. Um die Temperaturen, auf die das Trägerelement 2 bzw. die Hohlzylinder 4 und 5, geregelt werden, möglichst tief halten zu können, ist der Körper 6 und/oder können die Hohlzylinder 4 und 5 mit Kühlrippen versehen sein, um einen möglichst grossen Teil der zugeführten Verlustwärme an die Umgebung abzugeben.

Die Fig. 2 zeigt im Querschnitt eine Linearführung 1, bei der das Trägerelement 2 einen rechteckigen Querschnitt aufweist. Die Hohlzylinder 4, 5 des anhand der Fig. 1 erläuterten Ausführungsbeispiels sind ersetzt durch u-förmige Schlittenteile 14. Sichtbar ist auch ein im Trägerelement 2 angebrachtes Heizelement 12. Die Fig. 3 zeigt eine Linearführung 1, bei der der Schlitten 3 das Trägerelement 2 vollständig umschliesst.

Die erfindungsgemässe Linearführung 1 (Fig. 1) eignet sich insbesondere zur Verwendung in einem Pick and Place System eines Die Bonders. In diesem Fall trägt der Schlitten 3 einen Bondkopf mit einem Chipgreifer zum ergreifen, transportieren und plazieren von Halbleiterchips, wie es in der europäischen Patentanmeldung Nr. 98810988.0 beschrieben ist. Vorzugsweise ist das Trägerelement 2 als Teil eines in vertikaler Richtung heb- und senkbaren Rahmens ausgebildet, wobei der Rahmen zusätzlich mittels eines Mikromanipulators um typisch bis zu etwa 250 µm in horizontaler Richtung quer zur Längsrichtung des Trägerelementes 2 verschiebbar ist, während der Stator 8 ortsfest angeordnet ist.

## Patentansprüche

1. Linearführung (1), mit einem Trägerelement (2) und einem auf dem Trägerelement (2) gleitenden Schlitten (3), wobei der Schlitten (3) und das Trägerelement (2) durch einen mit Druckluft beaufschlagbaren Spalt (7) getrennt sind, **dadurch gekennzeichnet, dass** Heizelemente und/oder Kühlelemente vorgesehen sind, um die Temperatur des Trägerelementes (2) und/oder derjenigen Teile (4, 5; 14) des Schlittens (3), deren Temperatur die Dicke des Spalts (7) beeinflusst, innerhalb eines vorgegebenen Toleranzbandes zu halten.

2. Linearführung (1) nach Anspruch 1, **dadurch gekennzeichnet, dass** das Trägerelement (2) wenigstens ein Heizelement aufweist.

3. Linearführung (1) nach Anspruch 1 oder 2, **dadurch gekennzeichnet, dass** der Schlitten (3) wenigstens ein Heizelement (12) aufweist.

4. Linearführung (1) nach Anspruch 1, **dadurch gekennzeichnet, dass** das Trägerelement (2) Bohrungen (13) aufweist, die mit Druckluft oder mit einem Kühlmittel beaufschlagbar sind.

5. Linearführung (1) nach einem der Ansprüche 1 bis 4, **dadurch gekennzeichnet, dass** die Temperatur des Trägerelementes (2) und/oder die Temperatur derjenigen Teile (4, 5; 14) des Schlittens (3), deren Temperatur die Dicke des Spalts (7) beeinflusst, je auf einen vorbestimmten Wert geregelt ist.

6. Linearführung (1) nach einem der Ansprüche 1 bis 5, **dadurch gekennzeichnet, dass** als Antriebsvorrichtung für den Schlitten (3) ein Linearmotor vorgesehen ist, der einen Stator (8) und einen mit einem elektrischen Strom beaufschlagbaren Läufer (9) umfasst, und **dass** der Läufer (9) starr mit dem Schlitten (3) verbunden ist.

7. Die Bonder mit einem Pick and Place System, das eine Linearführung (1) nach Anspruch 6 umfasst.
